Europäisches Patentamt

European Patent Office

Office européen des brevets

(19)

(11) Numéro de publication : **0 138 637**
**B1**

(12)

# FASCICULE DE BREVET EUROPÉEN

(45) Date de publication du fascicule du brevet :
30.12.86

(51) Int. Cl.⁴ : **H 03 K 17/693**

(21) Numéro de dépôt : **84401641.0**

(22) Date de dépôt : **07.08.84**

(54) **Matrice de commutation de signaux électriques hyperfréquences.**

(30) Priorité : **17.08.83 FR 8313391**

(43) Date de publication de la demande :
**24.04.85 Bulletin 85/17**

(45) Mention de la délivrance du brevet :
**30.12.86 Bulletin 86/52**

(84) Etats contractants désignés :
**DE GB IT NL SE**

(56) Documents cités :
**DE-A- 2 339 757**
**FR-A- 2 041 027**
**IBM TECHNICAL DISCLOSURE BULLETIN, vol. 20,
no. 4, septembre 1977, pages 1311-1312, New York,
USA; G.H. PARIKH: "Phase or island isolation circuit"**

(73) Titulaire : **THOMSON-CSF**
**173, Boulevard Haussmann**
**F-75379 Paris Cedex 08 (FR)**

(72) Inventeur : **Magarshack, John**
**THOMSON-CSF SCPI 173, bld Haussmann**
**F-75379 Paris Cedex 08 (FR)**

(74) Mandataire : **Taboureau, James et al**
**THOMSON-CSF SCPI 19, avenue de Messine**
**F-75008 Paris (FR)**

## Description

Le domaine de la présente invention concerne une matrice de commutation, monolithique, fonctionnant dans la gamme des hyperfréquences. Elle est caractérisée en ce que tous les points de croisement de la matrice sont identiques et qu'ils sont réalisés avec des composants actifs, en particulier des transistors à effet de champ, qui ont du gain, ce qui permet de compenser ou d'équilibrer les pertes à chaque nœud de commutation.

Les matrices de commutation hyperfréquences sont utilisées en télécommunications pour commuter les voies d'un faisceau sans le démoduler en bandes de base. Elles sont réalisées avec des coupleurs de division-combinaison passifs, utilisant des microbandes accordées, et les commutateurs commandables sont des diodes PIN ou des transistors à effet de champ ; l'ensemble a une structure hybride qui par conséquent occupe une surface et un volume plus important qu'en circuit intégré. En outre, dans une matrice de commutation à éléments passifs, qui n'ont donc pas de gain propre, les points de croisement sont tous différents, selon leur position dans la matrice, car il y a lieu de tenir compte des pertes à chaque coupleur : le couplage est donc différent à chaque point et les coupleurs également.

La technologie monolithique est tout à fait adaptée à la réalisation de matrices de commutation et elle peut apporter un gain en volume et en dissipation thermique. Deux éléments de base sont utilisés : les diodes PIN et les transistors à effet de champ. Ces deux éléments correspondent à deux structures différentes dans lesquelles les circuits intégrés monolithiques apportent des solutions originales et intéressantes pour l'industrialisation des télécommunications en très haute fréquence.

La matrice de commutation selon l'invention est monolithique et elle met en œuvre des composants actifs dont le gain permet d'équilibrer les signaux commutés, indépendamment des pertes à la commutation comme cela a été dit. Ceci présente l'avantage que tous les points de commutation sont identiques entre eux, ce qui facilite la réalisation d'un circuit intégré. Dans la matrice de commutation selon l'invention, un signal provenant d'une première voie est divisé par un premier système, diviseur, utilisant au moins un transistor à effet de champ bi-drain ou bi-source ou deux transistors à effet de champ en parallèle. L'acheminement de ce signal vers une seconde voie est contrôlé par un transistor à effet de champ bi-grille, ou deux transistors à effet de champ en série, ou par une diode PIN. Le couplage du signal issu de la première voie avec la deuxième voie est obtenu par un second système, combineur, qui peut être identique au système de commutation, c'est-à-dire un transistor multigrille ou plusieurs transistors en série. En circuit intégré monolithique le croisement des voies de la matrice de commutation, qui sont réalisées sous forme de lignes métalliques en surface du substrat de la pastille de circuit intégré, est rendu possible par les techniques connues de pont isolé par une couche diélectrique ou à air — les deux voies se croisant dans l'air — ou de blindage multi-niveaux — les deux voies se croisant dans le matériau semiconducteur, ou passant d'une première face à une seconde face de la pastille du circuit intégré par l'intermédiaire de trous métallisés.

L'ensemble des moyens mis en œuvre pour réaliser une matrice de commutation selon l'invention est donc homogène puisqu'il s'agit de circuits intégrés et que sur une même pastille de matériaux semiconducteurs sont réalisés des transistors à effet de champ et des métallisations conductrices, éventuellement des diodes PIN. Ceci constitue un net avantage par rapport aux matrices de commutation connues qui sont réalisées par des techniques hybrides et des microbandes sur des substrats d'alumine ou d'oxyde de bérylium.

De façon plus précise l'invention concerne une matrice de commutation de signaux électriques hyperfréquences d'une première pluralité de voies d'entrée ou lignes vers une seconde pluralité de voies de sorties ou colonnes, le transfert d'un signal d'une voie d'entrée vers une voie de sortie étant effectué en un point de commutation, ladite matrice de commutation étant caractérisée en ce que chaque point de commutation comprend :

un diviseur de puissance, dont l'entrée reçoit le signal véhiculé par une voie d'entrée, et qui délivre à sa sortie un signal divisé en une pluralité de signaux égaux entre eux,

un commutateur commandable, commandé par un signal externe, qui transmet un signal provenant du diviseur à :

un combineur de puissance, qui transmet à une voie de sortie le signal transmis par le commutateur, l'ensemble des diviseurs de puissance, commutateur commandable et combineur de puissance étant réalisé par des composants actifs du type transistor à effet de champ.

L'invention sera mieux comprise par la description suivante de quelques exemples de réalisation, cette description s'appuyant sur les figures jointes en annexe et qui représentent :

figure 1  schéma général d'une matrice de commutation à distribution en série,

figure 2  réalisation d'un point de croisement selon l'art connu,

figure 3  réalisation d'un point de croisement selon l'invention pour une structure à distribution série,

figure 4  schéma général d'une matrice de commutation à distribution parallèle,

figure 5  réalisation d'un point de croisement selon l'invention pour une structure à distribution série.

figure 6  réalisation d'un point de croisement selon l'invention pour une structure à distribution parallèle.

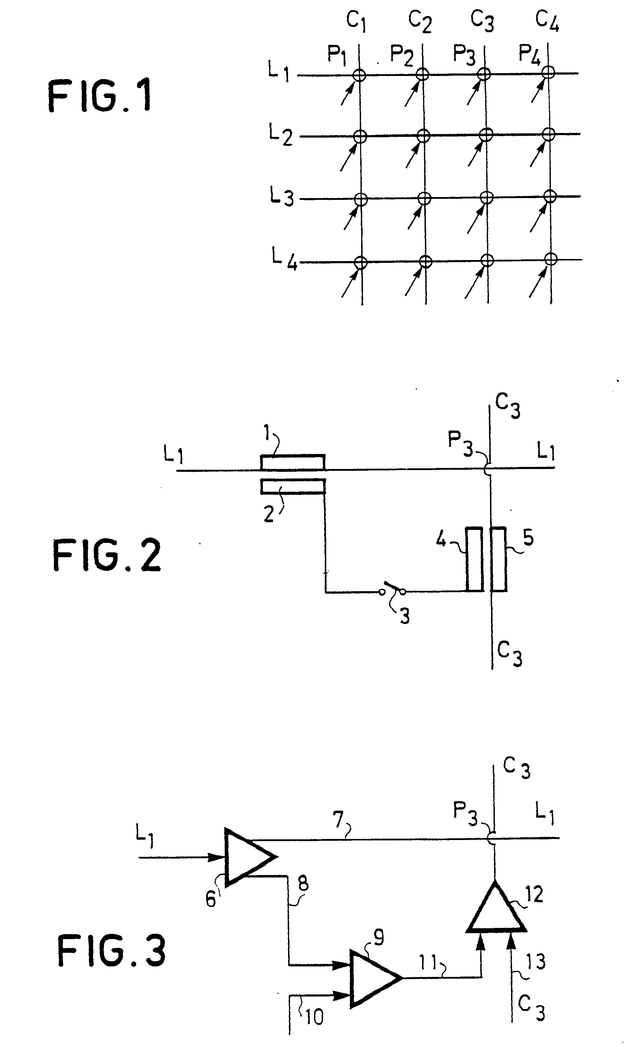

La figure 1 représente le schéma général d'une matrice de commutation à distribution série. Dans cette matrice de commutation, une pluralité de voies, qui dans le seul souci de simplification seront appelées des lignes, $L_1$ à $L_4$ par exemple, sont commutables avec une seconde pluralité de voies, qui seront également appelées par convention des colonnes $C_1$ à $C_4$. Une première voie telle que $L_1$ peut être commutée avec l'une quelconque des secondes voies $C_1$ à $C_4$, en un certain nombre de points de commutation qui sont repérés $P_1$ à $P_4$. A chaque point de commutation $P_1$ à $P_4$, une flèche sur la figure 1 symbolise l'action de commande par laquelle le signal provenant de la ligne $L_1$ peut être commuté à une ou plusieurs des colonnes $C_1$ à $C_4$.

Il est évident que la figure 1 ne représente qu'une faible partie d'une matrice de commutation, dans le souci de faciliter la lecture du dessin, alors qu'en réalité les matrices de commutation comportent un grand nombre de voies.

Jusqu'à présent, et tout au moins dans le domaine des hyperfréquences qui concerne l'invention, les matrices de commutation sont réalisées avec des moyens passifs représentés en figure 2.

Soit la ligne $L_1$ de la figure 1 qui doit être commutée avec la colonne $C_3$ par exemple. Selon l'art connu, la ligne $L_1$ comprend un coupleur constitué par une microbande 1 qui fait partie de la ligne $L_1$ et une seconde microbande 2 positionnée en parallèle avec la première microbande 1. L'énergie prélevée par le coupleur constitué par les microbandes 1 et 2 est dirigée vers la colonne $C_3$, qui comporte elle aussi un second coupleur constitué par une microbande 4 en liaison avec la microbande 2 de la ligne $L_1$ et une microbande 5 qui fait partie de la colonne $C_3$. Le couplage entre la ligne $L_1$ et la colonne $C_3$, est commandé par l'intermédiaire d'un interrupteur symbolisé en 3 : si l'interrupteur est ouvert, il n'y a pas de couplage au point de commutation $P_3$, tandis que si l'interrupteur est fermé il y a commutation. Jusqu'à présent les interrupteurs sont le plus souvent des diodes PIN et quelquefois des transistors à effet de champ.

Ce type de point de croisement est entièrement réalisé avec des moyens passifs, le transistor à effet de champ, s'il intervient comme interrupteur n'apporte pas de gain pour compenser les pertes au couplage. Ainsi, une matrice de commutation selon l'art antérieur comporte des pertes à chaque point de croisement $P_1$, $P_2$, $P_3$ ... $P_n$ et il faut tenir compte de ces pertes dans les coupleurs pour que l'énergie soit distribuée de façon régulière sur les colonnes du commutateur. Ainsi, les niveaux de couplage sont de $1/10^e$, $1/8^e$ etc... $1/2$ pour les différents points de croisement, ce qui suppose que dans la réalisation des microbandes leurs dimensions sont différentes pour chaque point de croisement.

Selon l'invention tous les points de croisement de la matrice de commutation sont identiques parce qu'ils sont réalisés avec des éléments actifs, transistors à effet de champ, qui ont du gain et qui peuvent être commandés par un signal électrique pour équilibrer l'énergie distribuée dans les colonnes de la matrice.

La figure 3 représente la réalisation d'un point de croisement selon l'invention pour une matrice de commutation à distribution en série. La figure 3 peut être avantageusement rapprochée de la figure 2 en ce sens que l'on a choisi de commuter la même ligne $L_1$ sur la même colonne $C_3$ pour faciliter la comparaison.

Les signaux provenant de la ligne $L_1$ sont d'abord divisés, pour chaque point de croisement, par un diviseur de puissance par deux, représenté sur la figure sous la forme d'un amplificateur 6 ayant deux sorties 7 et 8. Une première sortie 7 constitue la suite de la ligne $L_1$ et est dirigée vers le prochain point de croisement $P_4$ puisque la figure 3 représente, de façon démonstrative, le point de croisement $P_3$. La seconde sortie 8 est adressée à un commutateur commandable 9 : celui-ci reçoit sur une première entrée le signal issu du diviseur de puissance 6 et sur une seconde entrée un signal de commande 10. Le signal de sortie du commutateur commandable 9 est adressé à un combineur de puissance 12. Celui-ci reçoit sur une première entrée le signal 11 provenant de la ligne $L_1$ par l'intermédiaire du diviseur puissance 6 et du commutateur commandable 9. Il reçoit sur une seconde entrée le signal 13 de la colonne $C_3$ et le signal de sortie du combineur de puissance 12 constitue la sortie de la colonne $C_3$.

Les diviseurs de puissance, combineurs de puissance et commutateurs commandables de cette figure 3 sont représentés sous la forme de leur figure symbolique. En fait, le diviseur de puissance est un transistor bi-drain, ou un transistor bi-source, mais dans ce cas il n'y a pas de gain possible. Le diviseur de puissance 6 peut également être réalisé sous la forme d'un amplificateur différentiel ou de deux amplificateurs en parallèle : l'important est que le signal adressé à l'entrée du diviseur de puissance 6 soit séparé entre deux sorties 7 et 8.

Le commutateur commandable 9 est avantageusement un transistor à effet de champ bigrille : l'une pour recueillir le signal de sortie du diviseur de puissance 6, l'autre sur laquelle est appliqué le signal de commande 10. Le commutateur commandable peut également être constitué par deux transistors à effet de champ en série, lesquels sont équivalents à un unique transistor à effet de champ à deux grilles. De toute façon, il est souhaitable que le commutateur commandable 9 soit adapté pour les deux états binaires 0 et 1. L'isolation est très importante à l'état ouvert et elle doit être supérieure à 40 dB.

Le combineur de puissance 12 est un amplificateur à deux entrées et une sortie, pour lequel il est nécessaire qu'il n'y ait pas réciprocité entre entrée et sortie. Une forme préférée de réalisation de combineur de puissance est un transistor à effet de champ bi-grille, ce qui permet de simplifier la réalisation d'un circuit intégré puisque le diviseur de puissance 6, le commutateur commandable 9 et le combineur de puissance 12 sont réalisés par des transistors à effet de champ, c'est-à-dire selon une unique technologie. Le combineur de puissance 12 est soit un transistor à effet de champ bi-grille, soit constitué de deux transistors à effet de champ à une seule grille mais montés en série, comme pour le commutateur commandable.

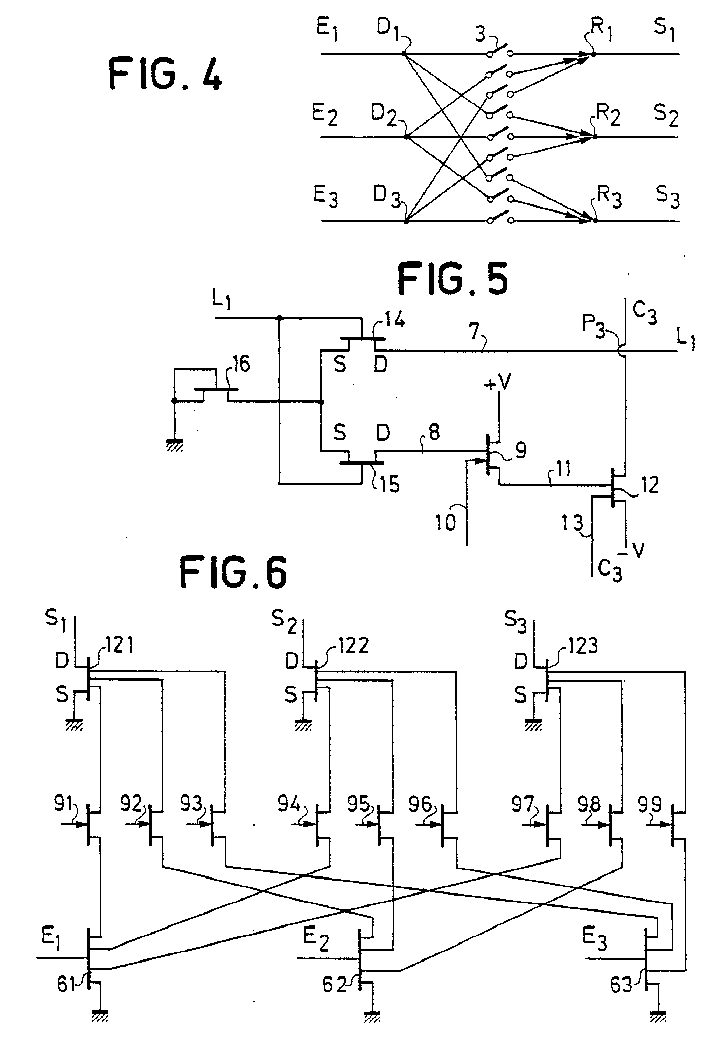

La figure 4 représente le schéma général d'une matrice de commutation à distribution parallèle. Selon la structure de cette matrice de commutation, une première voie telle que la voie $E_1$ peut être distribuée avec une pluralité d'autres voies telles que les voies de sortie $S_1$, $S_2$, $S_3$, non plus en série, mais en parallèle. Le signal issu de la voie d'entrée $E_1$ est divisé par un dispositif diviseur de puissance représenté par $D_1$ en une pluralité de signaux dont chacun passe par l'intermédiaire d'un commutateur commandable 3 avant d'être affecté à une voie de sortie, par l'intermédiaire d'un dispositif de recombinaison repéré $R_1$, $R_2$, $R_3$. Il est bien évident que le petit nombre de voies d'entrée $E_1$ à $E_3$ et de voies de sortie $S_1$ à $S_3$ n'a d'autre but que de simplifier la figure mais ne limite pas la portée du commutateur selon l'invention.

Dans une structure en parallèle, il n'y a pas de points de croisement tels que les points de croisement $P_1$ à $P_4$ qui étaient représentés sur la structure en série de la figure 1, mais chaque signal est divisé en un nombre égal au nombre de voies de sortie. Chaque voie est commutée séparément et les sorties sont regroupées et recombinées sur une sortie de la matrice en une seule opération.

Dans l'art connu, les diviseurs de puissance symbolisés par $D_1$ à $D_3$ sur la figure 4 sont des diviseurs combineurs Wilkinson montés en cascade. Selon l'invention ce sont des transistors à effet de champ à multi-entrées ou sorties, c'est-à-dire, selon le schéma adopté multi-sources ou multi-drains ou multi-grilles mais il est avantageux que ces transistors aient du gain pour maintenir constant le niveau du signal.

Les commutateurs commandables 3 sont également, et comme dans le cas précédent, des transistors à effet de champ bi-grille. Enfin les dispositifs de recombinaison $R_1$ à $R_3$ sont de préférence des transistors à effet de champ à multi-entrées ou multi-sorties, c'est-à-dire multi-sources, multi-drains ou multi-grilles. Il n'y a pas ambiguïté sur le fait que les systèmes de division ou de recombinaison sont des transistors à multi-sources, multi-drains ou multi-grilles : chaque montage a ses possibilités et ses inconvénients et le type de montage préféré pour réaliser un circuit intégré selon l'invention sera précisé ultérieurement : ce sont les montages qui simplifient la réalisation en circuit intégré et, préférentiellement, font appel au même type de transistor pour toutes les fonctions identiques des points de croisements dans un dispositif itératif.

La figure 5 est un premier exemple, non limitatif, de réalisation d'une matrice de commutation à structure série selon l'invention. La figure 5 reprend exactement le schéma de la figure 3 mais donne les détails de réalisation.

C'est ainsi que les signaux provenant d'une ligne $L_1$ sont couplés avec une colonne $C_3$ en un point de croisement $P_3$. Par comparaison avec la figure 3, on reconnaît que le système combineur 12 est un transistor à effet de champ à deux grilles, alimenté sur sa source par une tension $V^-$ et qui reçoit sur une première grille le signal 11 provenant du commutateur commandable 9, et sur une deuxième grille le signal 13 véhiculé par la colonne $C_3$.

Le commutateur commandable 9 de la figure 3 est ici réalisé par un transistor à effet de champ à deux grilles, alimenté par une tension $V^+$, qui reçoit sur une première grille le signal 8 issu du système diviseur de puissance et sur une deuxième grille le signal de commande 10. Il est avantageux pour la réalisation de l'invention que l'élément de commande 9 et l'élément combineur 12 soient deux transistors à effet de champ à deux grilles, réalisés selon la même technologie.

Enfin l'amplificateur-diviseur 6 de la figure 3 est ici réalisé sous la forme d'un amplificateur différentiel constitué par deux transistors à effet de champ 14 et 15. Ils sont montés en source commune et alimentés par un troisième transistor à effet de champ 16 monté en source de courant. Le signal véhiculé par la ligne $L_1$ de la matrice de commutation est appliqué simultanément sur les deux grilles des transistors 14 et 15, qui le divisent en deux signaux égaux, l'un est transmis en 7 sur la ligne $L_1$ et l'autre est transmis en 8 au commutateur commandable 9.

Au lieu d'un amplificateur différentiel constitué par les deux transistors 14 et 15, on aurait pu monter un unique transistor à une seule grille sur laquelle est appliqué le signal transmis sur la ligne $L_1$ et à deux drains, le premier drain correspondant à la ligne $L_1$ en 7 et le second drain correspondant au commutateur commandable en 8. On aurait pu également monter un unique transistor à une seule grille mais à deux sources, mais dans ce cas il n'y a pas de gain pour compenser les pertes de commutation. Enfin, on peut également monter deux amplificateurs en parallèle.

Le commutateur commandable 9 est ici représenté sous la forme d'un unique transistor à deux grilles : on sait que l'équivalent d'un tel transistor bi-grilles est constitué par deux transistors monogrilles montés en série. Ces deux transistors étant réunis par un drain et une source, la grille du premier transistor reçoit le signal provenant du diviseur de puissance, la grille du second transistor reçoit le signal de commande, tandis que la source du premier transistor reçoit la tension de polarisation et le drain du second transistor constitue la sortie du système qui est appliqué à une grille du combineur de signaux.

La figure 6 représente un exemple d'une matrice de commutation en parallèle selon la figure 4. Cependant, l'organisation en parallèle d'une telle matrice de commutation ne permet pas d'en isoler un point de croisement comme cela a été fait au sujet d'une matrice de commutation en série : il est nécessaire de représenter au moins deux points de croisement, et la figure 6 en prend 3, à titre non limitatif, pour mieux correspondre à la figure 4 dont elle donne le détail de réalisation.

Toutefois, afin de mieux faire ressortir l'unité de l'invention les diviseurs de puissance sont repérés 61, 62 et 63 sur cette figure 6 car ils correspondent aux diviseurs de puissance 6 de la précédente figure 3, tandis que les commutateurs commandables sont repérés 91, 99, et les combineurs de puissance repérés 121, 122 et 123, ce qui rappelle le commutateur commandable 9 et le combineur de puissance 12 de la figure 3.

Les signaux provenant de trois entrées $E_1$, $E_2$ et $E_3$ sont, dans une matrice de commutation en parallèle selon l'invention, appliqués sur les trois grilles de trois transistors à effet de champ 61, 62 et 63, qui correspondent aux systèmes diviseurs $D_1$, $D_2$ et $D_3$ de la figure 4. Ces transistors sont dotés d'une pluralité de drains, chaque transistor ayant autant de drains que de voies de sorties à alimenter, c'est-à-dire que dans le cas présent il y a trois drains pour trois voies de sorties. Les signaux issus des transistors diviseurs de puissances 61, 62 et 63 sont adressés à autant de transistors à effet de champ, repérés 91 à 99, qu'il y a de voies d'entrée multipliées par le nombre des voies de sortie. Ces transistors à effet de champ 91 à 99 sont les commutateurs commandables et peuvent être montés comme représenté sur la figure 6, le signal issu du diviseur 61 étant appliqué sur la source d'un transistor 91 ; ils peuvent être également des transistors bi-grilles, comme cela est représenté pour le transistor 9 de la figure 5 et les deux grilles reçoivent l'une le signal provenant d'un diviseur de puissance, l'autre le signal de commande. Dans le cas représenté sur la figure 6, une flèche sur la grille de chaque transistor de commande symbolise l'action de commande.

Enfin les signaux provenant des voies d'entrées sont appliqués à des transistors combineurs 121, 122 et 123, qui sont dotés chacun d'autant de grilles qu'il y a de voies d'entrées. Ces transistors à effet de champ 121, 122 et 123 ont leur source mise à la masse et les lignes de sortie $S_1$, $S_2$ et $S_3$ sont prises, chacune et respectivement, sur les drains des transistors 121, 122 et 123.

La figure 4 et son application de la figure 6 représentent trois voies d'entrées et trois voies de sorties, mais il est évident que ce cas ne limite pas la portée de l'invention qui peut être constitué par un nombre différent de lignes d'entrées, un nombre différent de lignes de sorties non égal au nombre des lignes d'entrées. Toutefois, pour une matrice de 8 entrées et 8 sorties ou 16 entrées et 16 sorties par exemple, il est préférable de regrouper les transistors combineurs 121, 122 et 123 en nombre tel que des transistors dotés de deux ou trois grilles permettent de combiner les différents signaux.

Un point particulier dans la matrice de commutation selon l'invention est constitué par le croisement des métallisations qui constituent les lignes d'entrées-sorties, ou les lignes et les colonnes selon le type de matrice. Dans tous les cas, on voit que des métallisations se croisent pour réunir un premier élément actif à un autre élément actif : étant donné que la matrice de commutation concerne essentiellement les hyperfréquences, il peut y avoir des problèmes de couplage au niveau de la pastille de matériaux semiconducteurs sur laquelle est réalisé le circuit intégré. C'est pourquoi parmi d'autres solutions possibles, des techniques connues telles que celles des ponts à air, ou du croisement de deux conducteurs par l'intermédiaire de trous métallisés dans la pastille sont des techniques éprouvées et préférables. De toute façon il peut être nécessaire, en vue d'éviter un couplage entre deux lignes métalliques qui se croisent, de procéder à un blindage, c'est-à-dire intercaler une métallisation mise à la masse entre les deux lignes métalliques, la métallisation étant séparée des deux lignes par deux couches isolantes.

**Revendications**

1. Matrice de commutation de signaux électriques hyperfréquences d'une première pluralité de voies d'entrée ou lignes ($L_i$) vers une seconde pluralité de voies de sorties ou colonnes ($C_i$), le transfert d'un signal d'une voie d'entrée ($L_1$) vers une voie de sortie ($C_3$) étant effectué en un point de commutation ($P_3$), ladite matrice de commutation étant caractérisée en ce que chaque point de commutation comprend :
   un diviseur de puissance (6, 61), dont l'entrée reçoit le signal véhiculé par une voie d'entrée ($L_1$), et qui délivre à sa sortie un signal divisé en une pluralité de signaux égaux entre eux (7, 8),
   un commutateur commandable (9, 91), commandé par un signal externe (10), qui transmet un signal (8) provenant du diviseur (6) à :
   un combineur de puissance (12, 121), qui combine le signal (11) transmis par le commutateur (9) à une voie de sortie (13 + $C_3$),
   l'ensemble des diviseurs de puissance (6), commutateur commandable (9) et combineur de puissance (12) étant réalisé par des composants actifs du type transistor à effet de champ.

2. Matrice de commutation selon la revendication 1, caractérisé en ce que sa structure est à distribution série, les points de commutation ($P_1$ à $P_4$) d'une même voie d'entrée ($L_1$) étant montés en série sur cette voie d'entrée ($L_1$) pour commuter vers une pluralité de voies de sorties ($C_1$ à $C_4$).

3. Matrice de commutation selon la revendication 1, caractérisé en ce que sa structure est à distribution parallèle, un même point de commutation ($D_1$) divisant le signal d'une voie d'entrée ($E_1$) vers une pluralité de voies de sorties ($S_1$ à $S_3$).

4. Matrice de commutation selon la revendication 1, caractérisée en ce que, en chaque point de commutation, le diviseur de puissance (6, 61) est l'un parmi :

transistor à effet de champ multi-drain (61) (avec gain) ou multi-source (sans gain)

amplificateur différentiel à transistors à effet de champ (14 + 15 + 16)

amplificateurs à transistors à effet de champ, en parallèle.

5. Matrice de commutation selon la revendication 1, caractérisée en ce que le commutateur commandable (9) est l'un parmi :

transistor à effet de champ bi-grille,

deux transistors monogrilles à effet de champ en série.

6. Matrice de commutation selon la revendication 1, caractérisée en ce que le combineur de puissance (12, 121) est l'un parmi :

un transistor à effet de champ multigrilles (121)

transistors monogrilles à effet de champ en série.

7. Matrice de commutation selon la revendication 1, caractérisée en ce que tous les points de commutation sont identiques entre eux.

8. Matrice de commutation selon la revendication 1, caractérisée en ce que, les éléments des points de commutation étant des transistors à effet de champ, les signaux divisés dans les diviseurs de puissance (6) sont ensuite amplifiés, par le gain des transistors.

9. Matrice de commutation selon la revendication 1, caractérisée en ce qu'elle est réalisée selon la technologie des circuits intégrés monolithiques.

10. Matrice de commutation selon la revendication 1, caractérisée en ce que, dans sa réalisation en circuit intégré monolithique, les croisements entre les métallisations constituant les voies d'entrées et les voies de sorties se font par pont d'air ou blindage multiniveaux.

## Claims

1. Matrix for switching electric hyperfrequency signals of a first plurality of input paths or lines $(L_i)$ to a second plurality of output paths or columns $(C_i)$, the transfer of a signal of one input path $(L_1)$ to an output path $(C_3)$ occurring at a switching point $(P_3)$, said switching matrix being characterized in that each switching point comprises :

a power divider (6, 61) the input of which receives the signal supplied by an input path $(L_1)$ and the output of which supplies a signal divided into a plurality of mutually identical signals (7, 8),

a controllable switch (9, 91) controlled by an external signal (10) and transmitting a signal (8) from the divider (6) to :

a power combiner (12, 121) which combines the signal (11) transmitted by the switch (9) with an output path $(13 + C_3)$,

the entirety of the power dividers (6), controllable switch (9) and power combiner (12) being embodied by active components of field effect transistor type.

2. Switching matrix according to claim 1, characterized in that its structure is of serial distribution, the switching points $(P_1$ to $P_4)$ of a same input path $(L_1)$ being mounted in series on this input path $(L_1)$ for switching to a plurality of output paths $(C_1$ to $C_4)$.

3. Switching matrix according to claim 1, characterized in that its structure is of parallel distribution, the same switching point $(D_1)$ dividing the signal of one input path $(E_1)$ into a plurality of output paths $(S_1$ to $S_3)$.

4. Switching matrix according to claim 1, characterized in that, at each switching point, the power divider (6, 61) is one among the following :

field effect transistor of multi-drain type (61) (with gain) or multi-source type (without gain)

differential amplifier of field effect transistor type (14 + 15 + 16),

amplifiers with field effect transistors in parallel.

5. Switching matrix according to claim 1, characterized in that the controllable switch (9) is one among the following :

dual-gate field effect transistor,

two field effect transistors of mono-gate type in series connection.

6. Switching matrix according to claim 1, characterized in that the power combiner (12, 121) is one among the following :

one multi-gate field effect transistor (121), series connected mono-gate field effect transistors.

7. Switching matrix according to claim 1, characterized in that all of the switching points are mutually identical.

8. Switching matrix according to claim 1, characterized in that, the elements of the switching points being field effect transistors, the signals divided in the power dividers (6) are subsequently amplified by the gain of the transistors.

9. Switching matrix according to claim 1, characterized in that it is embodied in the technology of monolithic integrated circuits.

10. Switching matrix according to claim 1, characterized in that, in an embodiment of a monolithic integrated circuit, the crossings between the metallizations constitute input paths and the output paths are provided by air bridges or multilevel screenings.

## Patentansprüche

1. Matrix zur Anschaltung von elektrischen Höchstfrequenzsignalen einer ersten Mehrzahl von Eingangskanälen oder Zeilen $(L_i)$ an eine zweite Mehrzahl von Ausgangskanälen oder Spalten $(C_i)$, wobei die Überführung eines Signals eines Eingangskanals $(L_1)$ zu einem Ausgangskanal $(C_3)$ an einem Schaltpunkt $(P_3)$ geschieht und wobei die genannte Schaltmatrix dadurch gekennzeichnet ist, daß jeder Schaltpunkt umfaßt :

einen Leistungsteiler (6, 61), dessen Eingang das über einen Eingangskanal $(L_1)$ zugeführte Signal empfängt und an seinem Ausgang ein Signal abgibt, welches in mehrere untereinander gleiche Signale (7, 8) unterteilt ist,

einen steuerbaren Schalter (9, 91), der durch ein externes Signal (10) gesteuert wird und ein von dem Teiler (6) kommendes Signal (8) überträgt zu :

einem Leistungskombinierer (12, 121), welcher das von dem Schalter (9) übertragene Signal (11) mit einem Ausgangskanal (13 + $C_3$) kombiniert, wobei die Gesamtheit der Leistungsteiler (6), des steuerbaren Schalters (9) und des Leistungskombinierers (12) durch aktive Bauelemente vom Typ eines Feldeffekttransistors verwirklicht ist.

2. Schaltmatrix nach Anspruch 1, dadurch gekennzeichnet, daß sie sie eine serielle Verteilerstruktur besitzt, wobei die Schaltpunkte ($P_1$ bis $P_4$) jeweils desselben Eingangskanals ($L_1$) in Reihe mit diesem Eingangskanal ($L_1$) geschaltet sind, um auf eine Mehrzahl von Ausgangskanälen ($C_1$ bis $C_4$) umzuschalten.

3. Schaltmatrix nach Anspruch 1, dadurch gekennzeichnet, daß sie eine parallele Verteilerstruktur aufweist, wobei jeweils derselbe Schaltpunkt ($D_1$) das Signal eines Eingangskanals ($E_1$) auf mehrere Ausgangskanäle ($S_1$ bis $S_3$) aufteilt.

4. Schaltmatrix nach Anspruch 1, dadurch gekennzeichnet, daß an jedem Schaltpunkt der Leistungsteiler (6, 61) einer von folgenden ist :

Multi-Drain-Feldeffekttransistor (61) (mit Verstärkung) oder Multi-Source-Feldeffekttransistor (ohne Verstärkung),

Differenzverstärker mit Feldeffekttransistoren (14 + 15 + 16),

Verstärker mit Feldeffekttransistoren in Parallelschaltung.

5. Schaltmatrix nach Anspruch 1, dadurch gekennzeichnet, daß der steuerbare Schalter (9) einer von folgenden ist :

Doppel-Gate-Feldeffekttransistor,

zwei Einfachgate-Feldeffekttransistoren in Serienschaltung.

6. Schaltmatrix nach Anspruch 1, dadurch gekennzeichnet, daß der Leistungskombinierer (12, 121) einer von folgenden ist :

Multi-Gate-Feldeffekttransistor (121),

Einfachgate-Feldeffekttransistoren in Serienschaltung.

7. Schaltmatrix nach Anspruch 1, dadurch gekennzeichnet, daß alle Schaltpunkte untereinander gleich sind.

8. Schaltmatrix nach Anspruch 1, dadurch gekennzeichnet, daß die Elemente der Schaltpunkte Feldeffekttransistoren sind und die in den Leistungsteilern (6) geteilten Signale anschließend durch die Verstärkung der Transistoren verstärkt werden.

9. Schaltmatrix nach Anspruch 1, dadurch gekennzeichnet, daß sie in der Technologie der monolithischen integrierten Schaltungen verwirklicht ist.

10. Schaltmatrix nach Anspruch 1, dadurch gekennzeichnet, daß bei Ausführung als monolithische integrierte Schaltung die Kreuzungspunkte zwischen den Metallisierungen die Eingangskanäle bilden und die Ausgangskanäle durch Luftbrücken oder Mehrfachniveau-Abschirmung gebildet sind.

0 138 637

FIG.1

FIG.2

FIG.3

# FIG. 4

# FIG. 5

# FIG. 6